(19) Europäisches Patentamt / European Patent Office / Office européen des brevets

(11) **EP 3 320 619 B1**

(12) **EUROPÄISCHE PATENTSCHRIFT**

(45) Veröffentlichungstag und Bekanntmachung des Hinweises auf die Patenterteilung:
**08.05.2019 Patentblatt 2019/19**

(21) Anmeldenummer: **16742190.8**

(22) Anmeldetag: **05.07.2016**

(51) Int Cl.:
*H03M 1/12* (2006.01)  *H03M 1/18* (2006.01)
*H03F 3/45* (2006.01)

(86) Internationale Anmeldenummer:
**PCT/EP2016/065845**

(87) Internationale Veröffentlichungsnummer:
**WO 2017/005743 (12.01.2017 Gazette 2017/02)**

(54) **SPANNUNGSVERSTÄRKER FÜR EINEN PROGRAMMIERBAREN SPANNUNGSBEREICH**

VOLTAGE AMPLIFIER FOR A PROGRAMMABLE VOLTAGE RANGE

AMPLIFICATEUR DE TENSION POUR PLAGE DE TENSION PROGRAMMABLE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **09.07.2015 DE 102015212842**

(43) Veröffentlichungstag der Anmeldung:
**16.05.2018 Patentblatt 2018/20**

(73) Patentinhaber: **Forschungszentrum Jülich GmbH 52425 Jülich (DE)**

(72) Erfinder: **GREWING, Christian 52428 Jülich (DE)**

(74) Vertreter: **dompatent von Kreisler Selting Werner - Partnerschaft von Patent- und Rechtsanwälten mbB**
**Deichmannhaus am Dom**
**Bahnhofsvorplatz 1**
**50667 Köln (DE)**

(56) Entgegenhaltungen:
**EP-A2- 1 111 794      WO-A2-2004/051858**
**US-A1- 2012 112 946    US-A1- 2014 232 577**
**US-B1- 8 193 962**

**Beschreibung**

**Gebiet der Erfindung**

Die Erfindung bezieht sich auf einen Spannungsverstärker für einen programmierbaren Spannungsbereich und zugehöriges Verfahren zur Spannungsverstärkung für einen programmierbaren Spannungsbereich.

**Hintergrund der Erfindung**

Durch die maximale Versorgungsspannung ist die Verstärkung des Eingangssignals begrenzt. Das Eingangssignal kann nur so weit verstärkt werden, als dass es noch linear verstärkt werden kann. Dieses Problem wird in Pipeline Analog-Digital-Wandlern (ADC) durch eine Rückkopplung des Signals gelöst. Das Signal wird anschließend durch einen oder mehrere Komparatoren ausgewertet und dieser Wert von dem Eingangssignal der Komparatoren abgezogen, um dann nur die Differenz, den sogenannten Restfehler zu verstärken. Pipeline ADC müssen aufwendig kalibriert werden, um unkontrollierte Veränderungen des Restfehlers infolge einer Verschiebung des Arbeitspunktes zu vermeiden. Pipeline ADC können somit nicht kurzfristig ein- und ausgeschaltet werden, da dies zu einer Verschiebung der Arbeitspunkte führen kann.

Die US 2014/0232577 A1 offenbart einen Analog-Digital-Wandler der eine erste und zweite Analog-Digital-Umwandlungszellen und eine Steuereinrichtung aufweist. Die Steuereinrichtung ist eingerichtet, ein Kontrollsignal zu erzeugen, das einen ersten und einen zweiten Eingangsbereich bezüglich des gleichen Spannungsbereiches und einen ersten und zweiten Zeitgeber zu verschiedenen Phasen erzeugt, wenn ein einen Modus spezifizieren des Signal einen ersten Modus anzeigt. Die Steuereinrichtung ist weiter eingerichtet, ein weiteres Kontrollsignal zu erzeugen, das den ersten und den zweiten Eingangsbereich bezüglich eines kontinuierlichen Spannungsbereiches und einen ersten und zweiten Zeitgeber zur gleichen Phase erzeugt, wenn ein einen Modus spezifizierendes Signal einen zweiten Modus anzeigt.

Die WO 2004/051858 A2 offenbart ein Verfahren, eine Vorrichtung und ein System zur Umwandlung einer Eingangsspannung in ein digitales Ausgangssignal. Basierend auf einem Vergleich mit einer Referenzspannung in einem oder mehreren (flash-type) Analog-Digital-Wandlern wird dazu verwendet das digitale Ausgangssignal zu erzeugen, dass die Eingangsspannung repräsentiert. Die Analog-Digital-Wandler sind linear, wenn mehrere Analog-Digital-Wandler verwendet werden.

**Zusammenfassung der Erfindung**

Es ist eine Aufgabe der vorliegenden Erfindung, einen Spannungsverstärker für einen programmierbaren Spannungsbereich zur Verfügung zu stellen.

Gemäß eines ersten Aspektes der Erfindung wird ein Spannungsverstärker für einen programmierbaren Spannungsbereich zur Verfügung gestellt. Der Spannungsverstärker weist zumindest einen ersten und einen zweiten Arbeitspunkt in Bezug auf ein Eingangsspannungssignal auf. Der Spannungsverstärker ist eingerichtet, einen ersten Bereich des Eingangsspannungssignals mittels des ersten Arbeitspunktes linear zu einem ersten Ausgangssignal zu transformieren. Der Spannungsverstärker ist weiter eingerichtet, einen zweiten Bereich des Eingangsspannungssignals mittels des zweiten Arbeitspunktes linear zu einem zweiten Ausgangssignal zu transformieren. Die Arbeitspunkte des Spannungsverstärkers sind in diesem Zusammenhang immer in Bezug zum Eingangsspannungssignal zu sehen. Verschiedene Bereiche des Eingangsspannungsignals werden zum Beispiel so verschoben, dass ein Verstärker, der Eingangsspannungen zwischen -5V und +5V linear verstärken kann, auch solche Bereiche des Eingangsspannungssignals linear verstärken kann, die außerhalb dieses Spannungsbereiches sind. Diese Bereiche werden auf definierte Weise in den Bereich verschoben, der linear verstärkt werden kann. Der Spannungsverstärker könnte zu diesem Zweck zum Beispiel einen einstellbaren Arbeitspunkt aufweisen, so dass neben dem ersten und dem zweiten Arbeitspunkt weitere Arbeitspunkte in Bezug auf das Eingangsspannungssignal eingestellt werden können. Das Eingangsspannungssignal könnte zum Beispiel mittels einstellbarer Widerstände bzw. Referenzpotenziale kontinuierlich oder diskret verschoben werden. Verschiedene Bereiche von periodischen Signalen könnten somit sukzessive linear verstärkt werden.

Der Spannungsverstärker könnte in einer alternativen Ausführungsform eingerichtet sein, den ersten Arbeitspunkt und den zweiten Arbeitspunkt zeitgleich zur Verfügung zu stellen. Es wäre somit insbesondere bei nicht periodischen Signalen möglich ein stark schwankendes Signal, das zum Beispiel zwischen -10 V und +10 V schwankt, mit zum Beispiel zwei Verstärkern linear zu verstärken, wobei die Verstärker nur bei einer Eingangsspannung zwischen -5V und +5V linear verstärken. Ein erster Bereich dieses Eingangsspannungssignals, der zwischen -10V und 0V liegt wird dabei in den Bereich des einen Verstärkers verschoben, in dem dieser linear verstärkt. Ein zweiter Bereich dieses Eingangsspannungssignals, der zwischen 0V und 10V und liegt wird dabei in den Bereich des anderen Verstärkers verschoben, in dem dieser linear verstärkt. Der erste Arbeitspunkt und der zweite Arbeitspunkt sind dabei vorzugsweise so eingestellt, dass der erste Bereich des Eingangsspannungssignals und der zweite Bereich des Eingangsspannungssignals mindestens einen gemeinsamen Wert aufweisen. Es ist dabei bevorzugt, dass der erste und der zweite Bereich mindestens teilweise unterschiedlich sind. Der erste und zweite Bereich könnten aber überlappen. Der erste Bereich des Eingangsspannungssignals und der zweite Bereich des Eingangsspannungssignals grenzen in einer alternativen Ausführungsform aneinander. Diese Ausführungsform hätte den Vorteil, dass ein Eingangsspannungssignal mit möglichst wenigen Komponenten linear verstärkt werden kann. Ein Überlappen der Bereiche könnte alternativ den Vorteil haben, dass durch die Redundanz eine Fehlererkennung und Kompensation ermöglicht bzw. erleichtert wird.

Der Spannungsverstärker ist vorzugsweise eingerichtet, das erste Ausgangssignal um einen vorgegebenen ersten Verstärkungsfaktor gegenüber dem ersten Bereich des Eingangsspannungssignals zu verstärken, und das zweite Ausgangssignal um einen vorgegebenen zweiten Verstärkungsfaktor gegenüber dem zweiten Bereich des Eingangsspannungssignals zu verstärken. Der erste und der zweite Verstärkungsfaktoren können unterschiedlich oder gleich gewählt sein.

Der Spannungsverstärker weist eine Regelstufe, mindestens einen Eingangsreferenzwiderstandsanordnung und eine Verstärkerschaltung auf. Der Spannungsverstärker kann zwei, drei oder mehr Regelstufen aufweisen. Der oder die Regelstufen sind eingerichtet, das Eingangsspannungssignal in ein oder mehrere Eingangsstromsignale zu transformieren. Die Eingangsreferenzwiderstandsanordnung ist eingerichtet, mittels des oder der Eingangsstromsignale zumindest ein erstes Abbild des ersten Bereichs des Eingangsspannungssignals und ein zweites Abbild des zweiten Bereichs des Eingangsspannungssignals zur Verfügung zu stellen, so dass das erste Abbild den ersten Arbeitspunkt in Bezug auf das Eingangsspannungssignal umfasst, und das zweite Abbild den zweiten Arbeitspunkt in Bezug auf das Eingangsspannungssignal umfasst. Die Verstärkerschaltung ist weiter eingerichtet, das erste Abbild zum ersten Ausgangssignal und das zweite Abbild zum zweiten Ausgangssignal zu transformieren.

Die Verstärkerschaltung ist in einer weiteren Ausführungsform eingerichtet, das erste Abbild zu einem ersten Ausgangstrom zu transformieren und das zweite Abbild zu einem zweiten Ausgangstrom zu transformieren. Die Verstärkerschaltung ist in diesem Fall vorzugsweise weiter eingerichtet, das erste Ausgangssignal als Spannungsabfall des ersten Ausgangsstroms über einem ersten Ausgangsreferenzwiderstand auszugeben, und das zweite Ausgangssignal als Spannungsabfall des zweiten Ausgangsstroms über einem zweiten Ausgangsreferenzwiderstand auszugeben. Der erste Ausgangsreferenzwiderstand und der zweite Ausgangsreferenzwiderstand können identisch oder verschieden sein. Der oder die Ausgangsreferenzwiderstände können auch einstellbar sein, was die Flexibilität der Schaltungsanordnung erhöhen könnte.

Die Verstärkerschaltung ist vorzugsweise eingerichtet, den ersten Ausgangsstrom um einen definierten ersten Stromverstärkungsfaktor gegenüber dem Eingangsstromsignal zu verstärken, und den zweiten Ausgangsstrom um einen definierten zweiten Stromverstärkungsfaktor gegenüber dem Eingangsstromsignal zu verstärken. Eine bevorzugte Ausführungsform könnte zum Beispiel einen oder mehrere Stromspiegel mit definierten Spiegelverhältnissen umfassen. Der erste Stromverstärkungsfaktor könnte gleich dem zweiten Stromverstärkungsfaktor oder unterschiedlich sein.

Die Verstärkerschaltung könnte in einer alternativen Ausführungsform mindestens einen ersten Verstärker und einen zweiten Verstärker aufweisen. Der erste Verstärker ist dabei vorzugsweise eingerichtet, das erste Abbild mittels einer ersten Gegenkopplung zum ersten Ausgangssignal zu transformieren. Der zweite Verstärker ist dabei vorzugsweise eingerichtet, das zweite Abbild mit einer zweiten Gegenkopplung zum zweiten Ausgangssignal zu transformieren. Die Verstärkerschaltung könnte auch 3, 4, 5 oder mehr Verstärker mit zugehöriger Gegenkopplung aufweisen. Die Gegenkopplung der einzelnen Verstärker kann gleich oder unterschiedlich gewählt werden. Die Verstärker können zum Beispiel Operationsverstärker sein.

Die erste Gegenkopplung ist in einer bevorzugten Ausführungsform gleich der zweiten Gegenkopplung (und auch gleich groß wie jede weiteren Gegenkopplung bei mehr als zwei Verstärkern). Der Spannungsverstärker ist dabei vorzugsweise eingerichtet, das erste Ausgangssignal mittels des ersten Verstärkers um den ersten Verstärkungsfaktor zu verstärken, und das zweite Ausgangssignal mittels des zweiten Verstärkers um den zweiten Verstärkungsfaktor zu verstärken. Der erste Verstärkungsfaktor kann gleich dem zweiten Verstärkungsfaktor oder unterschiedlich sein. Der Spannungsverstärker weist in einer bevorzugten Ausführungsform 3, 4, 5 oder mehr Verstärker auf, die als Operationsverstärker ausgeführt sind und mittels entsprechender Widerstandsschaltungen den gleichen Verstärkungsfaktor aufweisen.

Es ist eine weitere Aufgabe der vorliegenden Erfindung, eine Analog-Digital-Wandler Schaltungsanordnung zur Verfügung zu stellen. Die Analog-Digital-Wandler Schaltungsanordnung umfasst mindestens einen Spannungsverstärker der zuvor beschriebenen Art und mindestens einen Analog-Digital-Wandler. Der Analog-Digital-Wandler ist eingerichtet, mindestens das erste Ausgangssignal in ein erstes digitales Signal zu wandeln und mindestens das zweite Ausgangssignal in ein zweites digitales Signal zu wandeln. Die Wandlung kann bei periodischen Ausgangssignalen sukzessive erfolgen, so dass nur ein Analog-Digital-Wandler erforderlich ist. In einer bevorzugten Ausführungsform weist die Analog-Digital-Wandler Schaltungsanordnung 2, 3, 4 oder mehr Analog-Digital-Wandler auf, so dass verschiedene Bereiche des Eingangsspannungssignals gleichzeitig in ein digitales Signal umgewandelt werden können. Eine solche Anordnung könnte insbesondere bei nicht periodischen Signalen eine kontinuierliche Digitalisierung eines Eingangsspannungssignals ermöglichen.

Das erste digitale Signal repräsentiert vorzugsweise einen ersten linear transformierten Bereich des Eingangsspannungssignals, wenn das erste digitale Signal einen ersten Wert aufweist, wobei der erste Wert größer ist als ein erster minimaler digitaler Wert und kleiner als ein erster maximaler digitaler Wert ist. Das zweite digitale Signal repräsentiert vorzugsweise einen zweiten linear transformierten Bereich des Eingangsspannungssignal, wenn das zweite digitale Signal einen zweiten Wert aufweist, wobei der zweite Wert größer ist als ein zweiter minimaler digitaler Wert und kleiner als ein zweiter maximaler digitaler Wert ist. Bei mehreren Analog-Digital-Wandler weist somit in der Regel nur einer der Analog-Digital-Wandler einen Wert auf, der zwischen dem minimalen und maximalen digitalen Ausgangswert der Analog-Digital-Wandler liegt. Solche Analog-Digital-Wandler, die ein Ausgangssignal wandeln, das eine zu hohe oder zu niedrige Spannung aufweist, geben entweder den minimalen oder den maximalen digitalen Ausgangswert aus.

Es ist eine weitere Aufgabe der vorliegenden Erfindung, ein verbessertes Verfahren zur Spannungsverstärkung für einen programmierbaren Spannungsbereich zur Verfügung zu stellen. Das Verfahren umfasst die Schritte:

- Transformieren eines Eingangsspannungssignals, so dass ein erster Bereich des Eingangsspannungssignals in einen ersten definierten Bezug zu einem ersten Arbeitspunkt einer Verstärkerschaltung gesetzt wird, wobei das Eingangsspannungssignal in ein Eingangsstromsignal transformiert wird und mittels des Eingangsstromsignals ein erstes Abbild des ersten Bereichs des Eingangsspannungssignal zur Verfügung gestellt wird, sodass das erste Abbild den ersten Arbeitspunkt in Bezug auf das Eingangsspannungssignal umfasst,
- Transformieren des Eingangsspannungssignals, so dass ein zweiter Bereich des Eingangsspannungssignals in einen zweiten definierten Bezug zu einem zweiten Arbeitspunkt der Verstärkerschaltung gesetzt wird, wobei mittels des Eingangsstromsignals ein zweites Abbild des zweiten Bereichs des Eingangsspannungssignal zur Verfügung gestellt wird, sodass das zweite Abbild den zweiten Arbeitspunkt in Bezug auf das Eingangsspannungssignal umfasst,
- Linear Transformieren des ersten Bereiches mittels des ersten Abbilds zu einem ersten Ausgangssignal, und
- Linear Transformieren des zweiten Bereiches mittels des zweiten Abbilds zu einem zweiten Ausgangssignal.

Es ist eine weitere Aufgabe der vorliegenden Erfindung, ein verbessertes Verfahren Digitalisierung des Eingangsspannungssignals zur Verfügung zu stellen. Das Verfahren umfasst neben den zuvor genannten Schritten die zusätzlichen Schritte:

- Digitalisieren des ersten Ausgangssignals, und

- Digitalisieren des zweiten Ausgangssignals.

Die einzelnen Schritte des Verfahrens müssen nicht notwendigerweise in der angegebenen Reihenfolge durchgeführt werden.

Es wird klargestellt, dass die Filterschaltung gemäß Anspruch 1, der Analog-Digital-Wandler Schaltungsanordnung gemäß Anspruch 11 und das Verfahren gemäß Anspruch 13 ähnliche und/oder identische Ausführungsform aufweisen, wie sie insbesondere in den abhängigen Ansprüchen beschrieben werden.

Es wird weiterhin klargestellt, dass bevorzugte Ausführungsformen der Erfindung auch jede Kombination der abhängigen Ansprüche mit dem entsprechenden unabhängigen Ansprüchen darstellen.

Weitere bevorzugte Ausführungsformen werden im Folgenden beschrieben.

**Kurze Beschreibung der Abbildungen**

Diese und andere Aspekte der Erfindung werden im Detail in den Abbildungen wie folgt gezeigt.

Fig. 1 zeigt einen ersten Spannungsverstärker
Fig. 2 zeigt einen zweiten Spannungsverstärker
Fig. 3 zeigt einen Signalverlauf für den zweiten Spannungsverstärker
Fig. 4 zeigt einen dritten Spannungsverstärker
Fig. 5 zeigt einen Signalverlauf für den dritten Spannungsverstärker
Fig. 6 zeigt eine Schemaskizze eines vierten Spannungsverstärkers
Fig. 7 zeigt einen Analog-Digital-Wandler mit dem dritten Spannungsverstärker
Fig. 8 zeigt eine Schemaskizze eines Verfahrens zur Spannungsverstärkung

**Detaillierte Beschreibung der Ausführungsbeispiele**

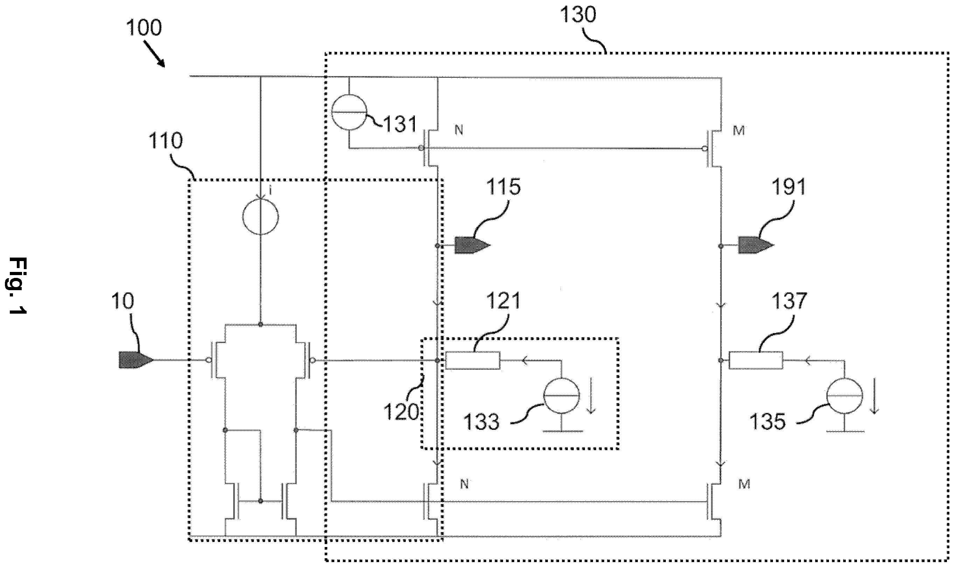

Fig. 1 zeigt einen ersten Spannungsverstärker 100. Der erste Spannungsverstärker 100 umfasst eine Regelstufe 110 mit einer Stromquelle und einem Differenzverstärker, der aus Feldeffekttransistoren aufgebaut ist. Der Eingang und damit das Eingangsspannungssignal 10 wird auf ein Gate eines selbstsperrenden ersten Feldeffekttransistors des Differenzverstärkers geleitet, wobei die Source dieses Feldeffekttransistors mit der Stromquelle verbunden ist. Der Ausgang des Differenzverstärkers ist dabei mit einem Gate eines selbstleitenden Feldeffekttransistors verbunden, der wiederum mit einem weiteren Gate eines zweiten selbstsperrenden Feldeffekttransistors des Differenzverstärkers verbunden ist, der gegen den ersten selbstsperrenden Feldeffekttransistor am Eingang geschaltet ist. Aufgrund dieser Schaltung liegt am Gate des zweiten selbstsperrenden Feldeffekttransistors die Eingangsspannung 115 an. Der erste Spannungsverstärker 100 weist zudem eine Verstärkerschaltung 130 auf, die in diesem Fall als Stromspiegel ausgeführt ist. Der erste Spannungsverstärker 100 umfasst eine Eingangsreferenzwiderstandsanordnung 120 mit einem Eingangsreferenzwiderstand 121 und einer Eingangsreferenzspannung 133. Die Eingangsreferenzspannung 133 ist mit dem Eingangsreferenzwiderstand 121 verbunden, der wiederum mit dem Gate des zweiten selbstsperrenden Feldeffekttransistors verbunden ist. Die Eingangsspannung liegt somit auch am Ausgang des Eingangsreferenzwiderstands an. Die Eingangsspannung beträgt somit:

$$V_{input} = R_{signal} * i_{signal} + v_{refinput}$$

wobei $R_{signal}$ den Eingangsreferenzwiderstand 121 und $V_{refinput}$ die Eingangsreferenzspannung 133 bezeichnet. Der Strom $i_{signal}$ bezeichnet den über den Eingangsreferenzwiderstand 121 fließenden Strom. Eine Biasspannung 131 ist zwischen den Eingängen der zwei selbstsperrenden Feldeffekttransistor des Stromspiegels der Verstärkerschaltung 130 und den zugehörigen Gates angelegt, wobei der Stromspiegel ein Spiegelverhältnis M/N aufweist. Es fließt somit ein Strom $i_{Bias}$ über den selbstsperrenden Feldeffekttransistor des Stromspiegels der mit dem Ausgang des Eingangsreferenzwiderstands 121 und dem Gate des zweiten selbstsperrenden Feldeffekttransistors des Differenzverstärkers verbunden ist. Über den selbstleitenden Feldeffekttransistor der Verstärkerschaltung 130 dessen Gate zur Rückkopplung des Eingangsspannungssignals 10 verwendet wird, fließt somit ein Strom $i_{Bias}+i_{signal}$. Auf der Ausgangsseite des Stromspiegels fließt somit aufgrund des Spiegelverhältnisses oberhalb eines Kontaktpunktes mit einer Ausgangsreferenzschaltung umfassend ein Ausgangsreferenzwiderstand 137 und einer Ausgangsreferenzspannung 135 ein Strom $(M/N)*i_{Bias}$ und unterhalb des Kontaktpunktes ein Strom $(M/N)*i_{Bias}+i_{signal}$. Über den Ausgangsreferenzwiderstand 137 fließt somit ein Strom $(M/N)*i_{signal}$. Ein erstes Ausgangssignal 191 ergibt sich somit im Fall des ersten Spannungsverstärkers 100 zu:

$$V_{output} = R_{output} * (M/N) * i_{signal} + v_{refoutput}$$

wobei $R_{output}$ den Ausgangsreferenzwiderstand 137 und $V_{refoutput}$ die Ausgangsreferenzspannung 135 bezeichnet. Der Arbeitspunkt des ersten Spannungsverstärkers 100 lässt sich somit mithilfe des Eingangsreferenzwiderstands 121, der Eingangsreferenzspannung 133, des Ausgangsreferenzwiderstands 137 und der Ausgangsreferenzspannung 135 in Bezug auf das eine Eingangsspannungssignal 10 im Wesentlichen frei einstellen. Verschiedenste Eingangsspannungssignale 10 können somit so angepasst werden, dass sie mittels der Verstärkerschaltung 130 linear verstärkt werden können. Um diese Einstellbarkeit zu gewähren, können zum Beispiel die Referenzwiderständen und auch die Referenzspannungen einstellbar ausgeführt werden. Die konkreten Werte für die Referenzwiderstände und auch die Referenzspannungen hängen dabei von der Anwendung, der Technologie und dem Gesamtkonzept ab. Bei der Verwendung des Spannungsverstärkers 100 in einer Analog-Digital-Wandler Schaltungsanordnung 500 ist dabei zum Beispiel auch die Anzahl der gewünschten Bits von Bedeutung.

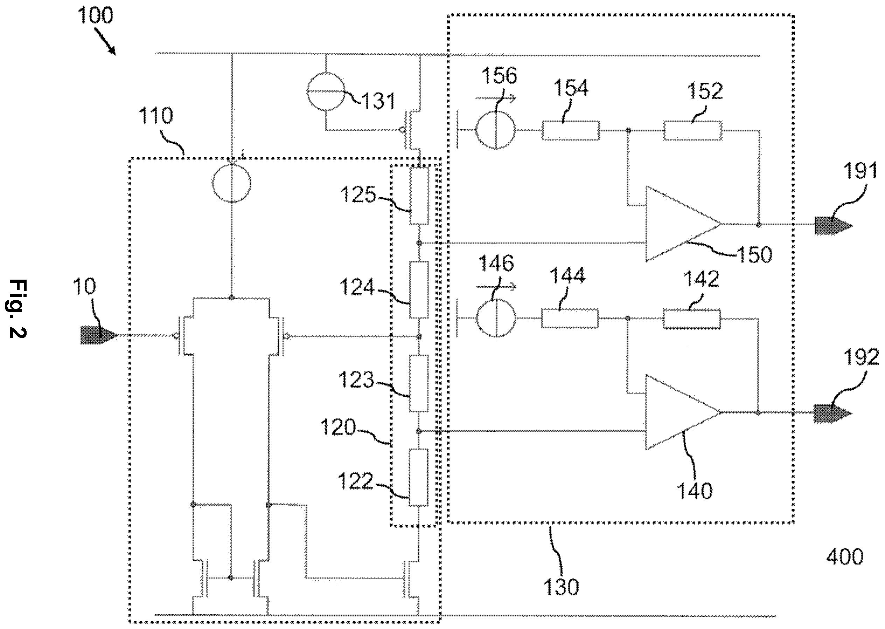

Fig. 2 zeigt einen zweiten Spannungsverstärker 100. Der zweite Spannungsverstärker 100 umfasst wieder eine Regelstufe 110 mit einer Stromquelle und einem Differenzverstärker, wobei das Ausgangssignal in analoger Weise auf den Differenzverstärker zurückgekoppelt ist, wie in Zusammenhang mit Fig. 1 erläutert. Ein Biasstrom wird in analoger Weise wie in Fig. 1 mittels einer Biasspannung 131 zur Verfügung gestellt, wobei dieser Biasstrom über die Eingangsreferenzwiderstände 122, 123, 124 und 125 der Eingangsreferenzwiderstandsanordnung 120 fließt. Die Eingangsreferenzwiderstände 122, 123, 124 und 125 sind nun so gewählt, dass zwischen den Eingangsreferenzwiderständen 122, 123, 124 und 125 jeweils definierte Potenziale eingestellt werden können, so dass verschiedene Arbeitspunkte einer Verstärkerschaltung 130 im Verhältnis zum Eingangsspannungssignal 10 eingestellt werden können. Die Verstärkerschaltung 130 weist dabei einen ersten Verstärker 140 auf dessen positiver Eingang mit Referenzwiderstandsanordnung 120 verbunden ist, wobei am positiven Eingang des ersten Verstärkers 140 das Potenzial zwischen dem ersten Eingangsreferenzwiderstand 122 und dem zweiten Eingangsreferenzwiderstand 123 anliegt. Der Ausgang des ersten Verstärkers 140 ist mit einem ersten Gegenkopplungswiderstand 142 gegengekoppelt. Der negative Ausgang des ersten Verstärkers 140 ist zudem über einen ersten Verstärkerwiderstand 144 mit einer ersten Verstärkerbiasspannung 146 verbunden. Die Verstärkung des ersten Verstärkers 140 wird mittels des ersten Gegenkopplungswiderstands 142 und des ersten Verstärkerwiderstands 144 eingestellt und kann auch den Wert 1 umfassen. Das Gate des selbstsperrenden Feldeffekttransistors im Eingang des Differenzwiderstands, der gegen den selbstsperrenden Feldeffekttransistor geschaltet ist, der das Eingangsspannungssignal 10 als Steuersignal aufnimmt, ist zwischen dem zweiten Eingangsreferenzwiderstand 123 und dem dritten Eingangsreferenzwiderstand 124 angeschlossen. An diesem Punkt liegt wie im Zusammenhang mit Fig. 1 diskutiert die Eingangsspannung an. Ein positiver Eingang eines zweiten Verstärkers 150, der ebenfalls von der Verstärkerschaltung 130 umfasst ist, ist zwischen dem dritten Eingangsreferenzwiderstand 124 und dem vierten Eingangsreferenzwiderstand 125 angeschlossen. Der Ausgang des zweiten Verstärkers 150 ist mit einem zweiten Gegenkopplungswiderstand 152 gegengekoppelt. Der negative Ausgang des zweiten Verstärkers 150 ist zudem über einen zweiten Verstärkerwiderstand 154 mit einer zweiten Verstärkerbiasspannung 156 verbunden. Die Verstärkung des zweiten Verstärkers 150 wird mittels des zweiten Gegenkopplungswiderstands 152 und des zweiten Verstärkerwiderstands 154 eingestellt. Im konkreten Ausführungsbeispiel der Fig. 2 weisen die einzelnen Komponenten die folgenden Werte auf: erster Eingangsreferenzwiderstand 122 den Wert R2, zweiter Eingangsreferenzwiderstand 123 den Wert R2/2, dritter Eingangsreferenzwiderstand 124 den Wert R2/2, vierter Eingangsreferenzwiderstand 125 den Wert R2, der erste und der zweite Verstärkerwiderstand 144, 154 jeweils den Wert R1, der erste und der zweite Gegenkopplungswiderstand 142, 152 jeweils die Werte 2*R1, die erste und die zweite Verstärkerbiasspannung 146, 156 sind gleich und weisen einen unterschiedlichen Wert auf als die Biasspannung 131 (Beispielwerte für die einzelnen Größen: R1= 5000hm (wird vor allem durch die Bandbreite des Signals gesetzt), R2=2000hm (Bei 1 mA Strom durch die Ausgangstufe der Regelung ergeben sich Spannungsabschnitte von jeweils 200mV, so dass die Ausgangsspannung bei einem Verhältnis der Werte der Widerstände 142 und 144 von 2 jeweils 200mV um die Verstärkerbiasspannung liegt), Verstärkerbiasspannung= Halber Versorgungsspannungsbereich, hängt vor allem von den folgenden Komparatoren ab, Biasspannung=zum Beispiel 300mV, sollte innerhalb des zu erwarteten Eingangsspannungsbereiches sein, um den Verstärker Bereich voll zu nutzen.). Die Potenziale an den positiven Eingängen des ersten und des zweiten Verstärkers in Relation zum andern Spannungssignal 10 lassen sich somit mittels der Eingangsreferenzwiderständen 122, 123, 124 und 125 einstellen. Wenn somit der erste und der zweite Verstärker 140, 150 den gleichen absoluten Arbeitspunkt aufweisen, lassen sich mittels der Eingangsreferenzwiderständen 122, 123, 124 und 124 verschiedene Arbeitspunkte im Verhältnis zum Eingangsspannungssignal 10 einstellen.

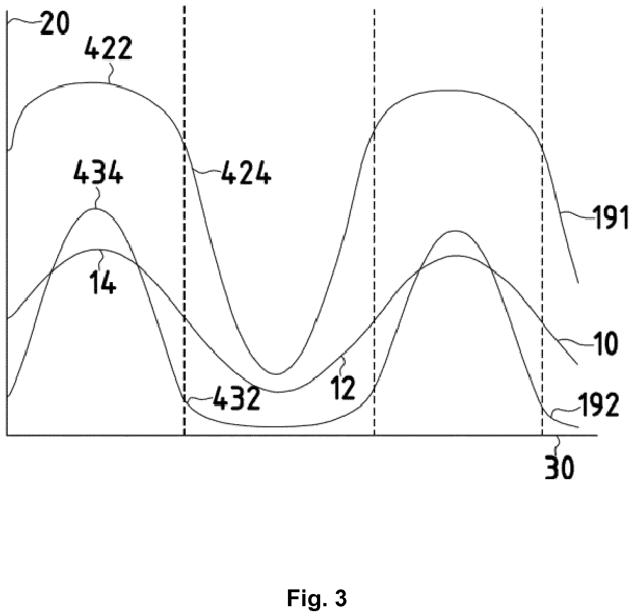

Die Fig. 3 zeigt einen Signalverlauf für den zweiten Spannungsverstärker 100. Die Signalamplitude 20 des Eingangsspannungssignals 10 ist hier über die Zeit 30 aufgetragen. Das Eingangsspannungssignal wird durch vertikale gestrichelte Linien in einen ersten Bereich 12 und einen zweiten Bereich 14 aufgeteilt. Das Eingangsspannungssignal 10 ist in diesem Fall sinusförmig und der zweite Bereich entspricht der positiven Halbwelle und der erste Bereich der negativen Halbwelle. Das zweite Ausgangssignal 192 weist im zweiten Bereich 14 des Eingangsspannungssignals 10 einen linearen Teil 434 auf. Der zweite Verstärker 150 weist in diesem zweiten Bereich des Eingangsspannungssignals 10 eine lineare Verstärkung auf. Diese lineare Verstärkung ist darauf zurückzuführen, dass die Spannung am positiven Eingang des zweiten Verstärkers 150 um den Wert $R2/2*i_{Bias}$ in Relation zur Eingangsspannung vermindert ist. Im ersten Bereich 12 des Eingangsspannungssignals 10 übersteuert der zweite Verstärker 150 und gibt ein nichtlineares Signal 432 aus. Das erste Ausgangssignal 191 weist im ersten Bereich 12 des Eingangsspannungssignals 10 einen linearen Teil 424 auf. Der erste Verstärker 140 weist in diesem ersten Bereich des Eingangsspannungssignals 10 eine lineare Verstärkung auf. Diese lineare Verstärkung ist darauf zurückzuführen, dass die Spannung am positiven Eingang des ersten Verstärkers 140 um den Wert $R2/2*i_{Bias}$ in Relation zur Eingangsspannung erhöht ist. Im zweiten Bereich 14 des Eingangsspannungssignals 10 übersteuert der erste Verstärker 140 und gibt ein nichtlineares Signal 422 aus.

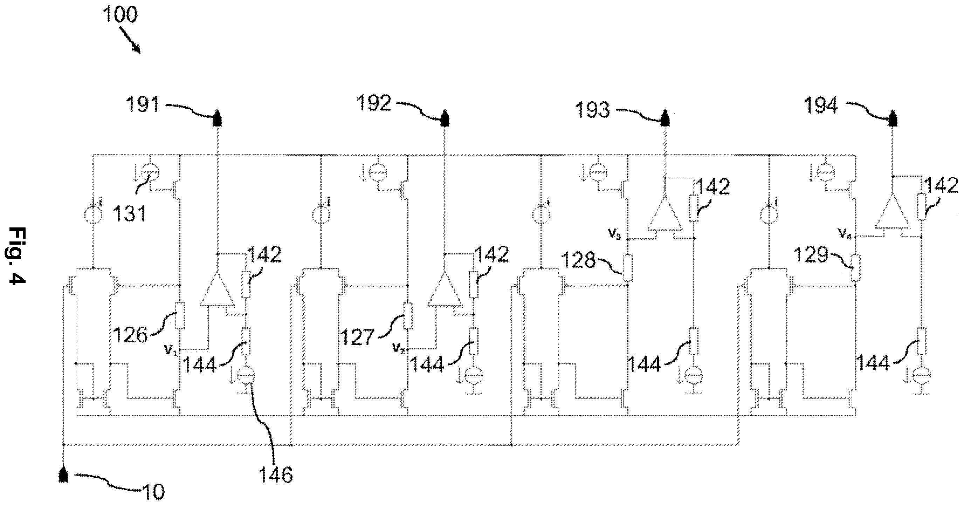

Fig. 4 zeigt einen dritten Spannungsverstärker 100 mit 4 Ausgängen. Die prinzipielle Schaltung des Spannungsverstärkers 100 ist sehr ähnlich zu der in Fig. 2. Anders als in der Fig. 2 wird allerdings pro Ausgang eine Regelstufe 110 am Eingang zur Verfügung gestellt. Die Festlegung der Arbeitspunkte der 4 parallel angeordneten Verstärker im Verhältnis zu Eingangsspannungssignal 10 erfolgt wieder mittels der Eingangsreferenzwiderstandsanordnung, die 4 Eingangsreferenzwiderstände126, 127, 128 und 129 aufweist. Das an dem positiven Eingängen der Verstärker anliegende Potenzial (V1, V2, V3, V4) wird dabei durch die Stellung der Kontaktpunkte relativ zu den Eingangsreferenzwiderständen126, 127, 128 und 129 im Strompfad der jeweiligen Biasströme (gleich groß gewählt) und der Größe der Eingangsreferenzwiderstände 126, 127, 128 und 129 bestimmt. Im konkreten Ausführungsbeispiel der Fig. 2 weisen die einzelnen Komponenten die folgenden Werte auf: fünfter Eingangsreferenzwiderstand 126 den Wert 1,5*R2, sechster Eingangsreferenzwiderstand 127 den Wert R2/2, siebter Eingangsreferenzwiderstand 128 den Wert R2/2, vierter Eingangsreferenzwiderstand 129 den Wert 1,5*R2, die Verstärkerwiderstände 144 jeweils den Wert R1, die Gegenkopplungswiderstände 142 jeweils die Werte n*R1, die erste Verstärkerbiasspannung 146 ist für alle Verstärker gleich und weist einen unterschiedlichen Wert auf als die Biasspannung 131.

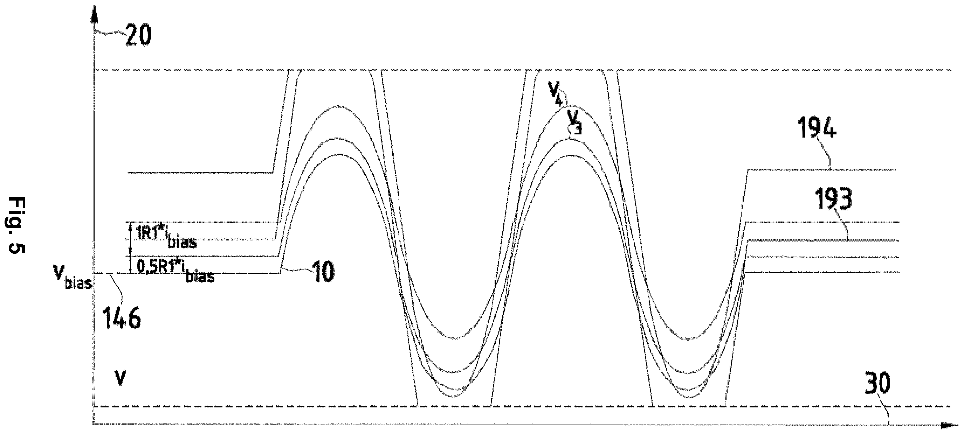

Fig. 5 zeigt einen Signalverlauf für den dritten Spannungsverstärker 100 wie er in Fig. 4 beschrieben wird. Es wird das Eingangsspannungssignal 10, die Spannung V3 am positiven Eingang des dritten Verstärkers, die Spannung V4 am positiven Eingang des vierten Verstärkers, das dritte Ausgangssignal 193 und das vierte Ausgangssignal 194 gezeigt. Die Spannungen V3 und V4 sind durch die Eingangsreferenzwiderstände 128 und 129 gegen das Eingangsspannungssignal 10 verschoben. Es werden somit verschiedene Arbeitspunkte der Verstärker im Verhältnis zum Eingangsspannungssignal 10 mittels der Eingangsreferenzwiderstände 128 und 129 festgelegt. Die Konsequenz der Verschiebung zeigt sich im dritten und vierten Ausgangssignal 193 und 194, wo zu sehen ist, dass das Eingangsspannungssignal 10 vom jeweiligen Verstärker nur in bestimmten Bereichen linear verstärkt wird. Es ist somit möglich ein Eingangsspannungssignal 10 in verschiedene Amplitudenbereiche aufzuteilen (zum Beispiel -10 V bis -5 V, -5 V bis 0 V, 0 V bis 5 V, 5 V bis 10 V) und diese Amplitudenbereiche durch die einzelnen Verstärker getrennt voneinander linear zu verstärken. Die beiden waagerechten gestrichelten Begrenzungslinien bezeichnen dabei am unteren Rand das Massepotenzial in Relation zur Versorgungsspannung und am oberen Rand die Versorgungsspannung.

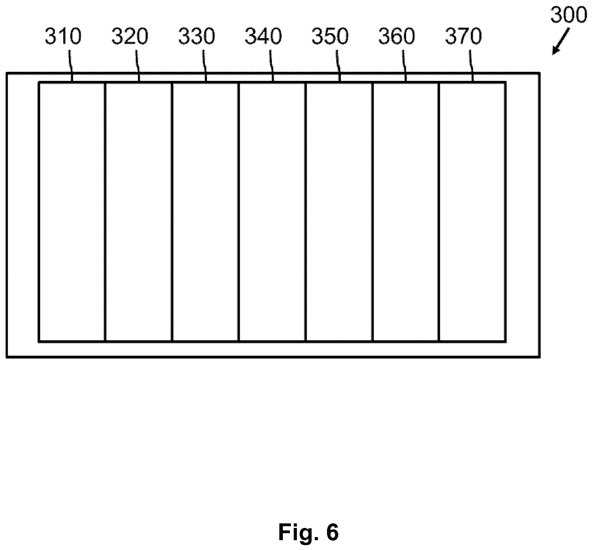

Fig. 6 zeigt eine Schemaskizze eines vierten Spannungsverstärkers 300 wie aus der Diskussion der Figuren 1 bis 3 klar wird, lässt sich der erfindungsgemäße Spannungsverstärker 300 durch verschiedenste konkrete Schaltungsanordnungen realisieren. Eine beispielhafte schematische Darstellung des vierten Spannungsverstärkers umfasst ein Bias 310, einen Eingangsbuffer 320, eine Eingangsreferenzwiderstandsanordnung 330, eine Regelung des Eingangs 340, ein Ausgang 350, eine Ausgangswiderstandsanordnung 360 und eine Regelung des Ausgangs 370. Der in Fig. 6 schematisch skizzierte Schaltplan des vierten Spannungsverstärkers 300 lässt sich sowohl durch integrierte Schaltungen, als auch durch herkömmliche Schaltungstechnik ausführen.

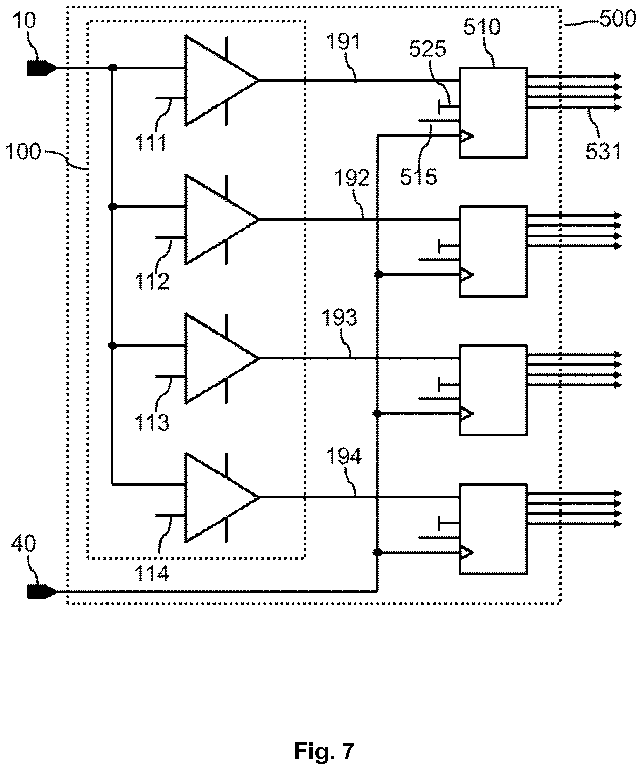

Fig. 7 zeigt einen Analog-Digital-Wandler Schaltungsanordnung mit dem dritten Spannungsverstärker 100. Jede der 4 Verstärkungszweige mit den unterschiedlichen Eingangsreferenzspannungen 111, 112, 113 und 114 weist einen der in Fig. 4 gezeigten Verstärker auf, die die Ausgangssignale 191, 192, 193 und 194 ausgeben. Jedes dieser Ausgangssignale 191, 192, 193 und 194 wird an einen eindeutig zugeordneten Analog-Digital-Wandler 510 weitergeleitet. Jeder dieser Analog-Digital-Wandler 510 ist mit der Masse 525 und einer in diesem Fall einheitlichen Referenzspannung 515 verbunden. Die Analog-Digital-Wandler 510 geben nun digitale Signale 531 aus. Die Ausgangssignale 191, 192, 193 und 194 sowie die Referenzspannung 515 sind nun so gewählt, dass nur einer der vier Analog-Digital-Wandler 510 einen digitalen Wert ausgibt, der zwischen einem minimalem und maximalen digitalen Wert liegt. Die drei anderen Analog-Digital-Wandler 510 empfangen Ausgangssignale 191, 192, 193 oder 194, die eine zu hohe Spannung oder eine zu niedrige Spannung aufweisen. Diese 3 Analog-Digital-Wandler 510 geben somit entweder den minimalen digitalen Wert (zum Beispiel 0000) oder den maximalen digitalen Wert (zum Beispiel 1111) aus. Der linear verstärkte Bereich des Eingangs Spannungssignals 10 kann somit auf einfache Weise durch Vergleich der digitalen Signale 531 an den Ausgängen der Analog-Digital-Wandler 510 bestimmt werden. Die digitalen Signale 531 werden dabei in zeitdiskreten Schritten ausgegeben, die durch eine Clock 40 bestimmt werden. In dem Fall, in dem die Ausgangssignale genau auf der Grenze zwischen zwei Bereichen des Eingangsspannungssignals 10 liegen, gibt der oder die Analog-Digital-Wandler 510 den korrekten Wert aus, bei dem der maximale digitale Wert zum minimalen digitalen Wert oder umgekehrt wechselt.

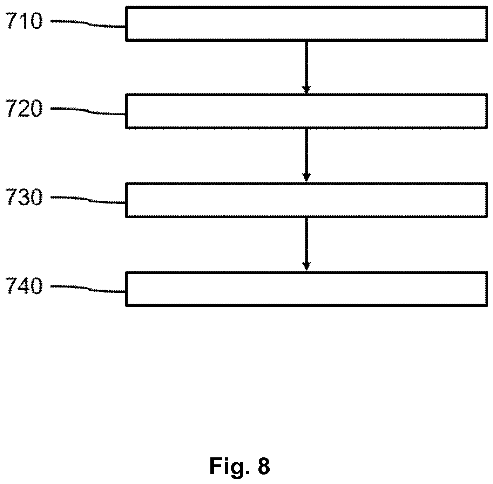

Fig. 8 zeigt eine Schemaskizze eines Verfahrens zur Spannungsverstärkung. In Schritt 710 wird ein Eingangsspannungssignal 10 so transformiert, dass ein erster Bereich 12 des Eingangsspannungssignals 10 in einen ersten definierten Bezug zu einem ersten Arbeitspunkt einer Verstärkerschaltung gesetzt wird. In Schritt 720 wird ein Eingangsspannungssignal 10 so transformiert, dass ein zweiter Bereich 14 des Eingangsspannungssignals 10 in einen zweiten definierten Bezug zu einem zweiten Arbeitspunkt der Verstärkerschaltung gesetzt wird. In Schritt 730 wird der erste Bereich 12 linear zu einem ersten Ausgangssignal 191 transformiert. In Schritt 740 wird der zweite Bereich 14 linear zu einem zweiten Ausgangssignal 192 transformiert.

Es ist eine Idee der vorliegenden Erfindung definierte Bereiche 12, 14 eines Eingangsspannungssignals 10 in unterschiedliche Bezüge im Verhältnis zum Eingangsspannungssignal zu einem oder mehreren Arbeitspunkten einer Verstärkerschaltung 130 zu setzen. Bei entsprechender Aufteilung der Bereiche 12, 14 des Eingangsspannungssignals 10 ist es möglich, die jeweiligen Bereiche 12, 14 linear zu verstärken. Solche linear verstärkten Ausgangssignale können sodann zum Beispiel mittels mehrerer Analog-Digital-Wandler 510 in digitale Signale umgewandelt werden. Es ist somit möglich, mittels relativ einfacher Analog-Digital-Wandler 510 ein hochaufgelöstes digitales Signal 531 zu erhalten. Eine aufwändige Kalibrierung, wie sie zum Beispiel im Falle von Pipeline ADCs durchgeführt werden muss, ist nicht erforderlich.

Weitere Varianten der Erfindung und ihre Ausführung ergeben sich für den Fachmann aus der vorangegangenen Offenbarung, den Figuren und den Patentansprüchen.

In den Patentansprüchen verwendete Begriffe wie "umfassen", "aufweisen", "beinhalten", "enthalten" und dergleichen schließen weitere Elemente oder Schritte nicht aus. Die Verwendung des unbestimmten Artikels schließt eine Mehrzahl nicht aus. Eine einzelne Einrichtung kann die Funktionen mehrerer in den Patentansprüchen genannten Einheiten bzw. Einrichtungen ausführen. In den Patentansprüchen angegebene Bezugszeichen sind nicht als Beschränkungen der eingesetzten Mittel und Schritte anzusehen.

**Liste der Bezugszeichen**

| | |
|---|---|
| 10 | Eingangsspannungssignal |
| 12 | erster Bereich |
| 14 | zweiter Bereich |
| 20 | Signalamplitude |
| 30 | Zeitachsen |
| 40 | Clock |
| 100, 300 | Spannungsverstärker |
| 110 | Regelstufe |
| 111 | erster Eingangsreferenzspannung |
| 112 | zweiter Eingangsreferenzspannung |
| 113 | dritte Eingangsreferenzspannung |
| 114 | vierte Eingangsreferenzspannung |

| 115 | Eingangsspannung |
| 120, 330 | Eingangsreferenzwiderstandsanordnung |
| 121 | Eingangsreferenzwiderstand |
| 122 | erster Eingangsreferenzwiderstand |
| 123 | zweiter Eingangsreferenzwiderstand |
| 124 | dritter Eingangsreferenzwiderstand |
| 125 | vierter Eingangsreferenzwiderstand |
| 126 | fünfter Eingangsreferenzwiderstand |
| 127 | sechster Eingangsreferenzwiderstand |
| 128 | siebter Eingangsreferenzwiderstand |
| 129 | achter Eingangsreferenzwiderstand |
| 130 | Verstärkerschaltung |
| 131 | Biassppannung |
| 133 | Eingangsreferenzspannung |
| 135 | Ausgangsreferenzspannung |
| 137 | Ausgangsreferenzwiderstand |
| 140 | erster Verstärker |
| 142 | erster Gegenkopplungswiderstand |
| 144 | erster Verstärkerwiderstand |
| 146 | erste Verstärker Bias Spannung |
| 150 | zweiter Verstärker |
| 152 | zweiter Gegenkopplungswiderstand |
| 154 | zweiter Verstärkerwiderstand |
| 156 | zweite Verstärker Bias Spannung |
| 191 | erstes Ausgangssignal |
| 192 | zweites Ausgangssignal |
| 193 | drittes Ausgangssignal |
| 194 | viertes Ausgangssignal |
| 310 | Bias |
| 320 | Eingangsbuffer |
| 340 | Regelung Eingang |
| 350 | Ausgang |
| 360 | Ausgangswiderstandsanordnung |
| 370 | Regelung Ausgang |
| 422 | nichtlinearer Teil des ersten Ausgangssignals |
| 424 | linearer Teil des ersten Ausgangssignals |
| 432 | nichtlinearer Teil des zweiten Ausgangssignals |
| 434 | linearer Teil des zweiten Ausgangssignals |
| 500 | Analog-Digital-Wandler Schaltungsanordnung |
| 510 | Analog-Digital-Wandler |
| 515 | Referenzspannung |
| 525 | Masse |
| 531 | digitales Signal |
| 710 | Transformieren eines ersten Bereich |
| 720 | Transformieren eines zweiten Bereich |
| 730 | linear Transformieren des ersten Bereich |
| 740 | linear Transformieren des zweiten Bereich |

**Patentansprüche**

1. Ein Spannungsverstärker (100, 300) für einen programmierbaren Spannungsbereich, wobei der Spannungsverstärker (100, 300) zumindest einen ersten und einen zweiten Arbeitspunkt in Bezug auf ein Eingangsspannungssignal (10) aufweist, und wobei der Spannungsverstärker (100, 300) eingerichtet ist, einen ersten Bereich (12) des Eingangsspannungssignals (10) mittels des ersten Arbeitspunktes linear zu einem ersten Ausgangssignal (191) zu transformieren, und wobei der Spannungsverstärker (100, 300) weiter eingerichtet ist einen zweiten Bereich (14) des Eingangsspannungssignals (10) mittels des zweiten Arbeitspunktes linear zu einem zweiten Ausgangssignal (192) zu transformieren, wobei der Spannungsverstärker (100, 300) eine Regelstufe (110), mindestens eine Eingangsreferenzwiderstandsanordnung (120, 330) und eine Verstärkerschaltung (130) aufweist, wobei die Regelstufe (110) eingerichtet ist, das Eingangsspannungssignal (10) in ein Eingangsstromsignal zu transformieren, die mindestens eine Eingangsreferenzwiderstandsanordnung (120, 330) eingerichtet ist, mittels des Eingangsstromsignals ein erstes Abbild des ersten Bereichs (12) des Eingangsspannungssignals (10) und ein zweites Abbild des zweiten Bereichs (14) des Eingangsspannungssignals (10) zur Verfügung zu stellen, so dass das erste Abbild den ersten Arbeitspunkt in Bezug auf das Eingangsspannungssignal (10) umfasst, und das zweite Abbild den zweiten Arbeitspunkt in Bezug auf das Eingangsspannungssignal (10) umfasst, und wobei die Verstärkerschaltung (130) eingerichtet ist, das erste Abbild zum ersten Ausgangssignal (191) und das zweite Abbild zum zweiten Ausgangssignal (192) zu transformieren.

2. Der Spannungsverstärker (100, 300) gemäß Anspruch 1, wobei der Spannungsverstärker (100, 300) einen einstellbaren Arbeitspunkt aufweist, so dass neben dem ersten und dem zweiten Arbeitspunkt weitere Arbeitspunkte in Bezug auf das Eingangsspannungssignal (10) eingestellt werden können.

3. Der Spannungsverstärker (100, 300) gemäß Anspruch 1, wobei der Spannungsverstärker (100, 300) eingerichtet ist, den ersten Arbeitspunkt und den zweiten Arbeitspunkt zeitgleich zur Verfügung zu stellen.

4. Der Spannungsverstärker (100, 300) gemäß Anspruch 3, wobei der erste Arbeitspunkt und der zweite Arbeitspunkt so eingestellt sind, dass der erste Bereich (12) des Eingangsspannungssignal (10) und der zweite Bereich (14) des Eingangsspannungssignal (10) mindestens einen gemeinsamen Wert aufweisen.

5. Der Spannungsverstärker (100, 300) gemäß Anspruch 4, wobei der erste Bereich (12) des Eingangsspannungssignals (10) und der zweite Bereich (14) des Eingangsspannungssignals (10)aneinander grenzen.

**6.** Der Spannungsverstärker (100, 300) gemäß einem der vorausgehenden Ansprüche, wobei der Spannungsverstärker (100, 300) eingerichtet ist, das erste Ausgangssignal (191) um einen vorgegebenen ersten Verstärkungsfaktor gegenüber dem ersten Bereich (12) des Eingangsspannungssignals (10) zu verstärken, und wobei der Spannungsverstärker (100, 300) eingerichtet ist, das zweite Ausgangssignal (192,) um einen vorgegebenen zweiten Verstärkungsfaktor gegenüber dem zweiten Bereich des Eingangsspannungssignals (10) zu verstärken.

**7.** Der Spannungsverstärker (100, 300) gemäß Anspruch 6, wobei die Verstärkerschaltung (130) eingerichtet ist, das erste Abbild zu einen ersten Ausgangstrom zu transformieren und das zweite Abbild zu einem zweiten Ausgangsstrom zu transformieren, und wobei die Verstärkerschaltung (130) weiter eingerichtet ist, das erste Ausgangssignal (191) als Spannungsabfall des ersten Ausgangsstroms über einem ersten Ausgangsreferenzwiderstand (137) auszugeben, und das zweite Ausgangssignal als Spannungsabfall des zweiten Ausgangsstroms über einem zweiten Ausgangsreferenzwiderstand (137) auszugeben.

**8.** Der Spannungsverstärker (100, 300) gemäß Anspruch 7, wobei die Verstärkerschaltung (130) eingerichtet ist, den ersten Ausgangsstrom um einen definierten ersten Stromverstärkungsfaktor gegenüber dem Eingangsstromsignal zu verstärken, und den zweiten Ausgangsstrom um einen definierten zweiten Stromverstärkungsfaktor gegenüber dem Eingangsstromsignal zu verstärken.

**9.** Der Spannungsverstärker (100, 300) gemäß Anspruch 1, wobei die Verstärkerschaltung (130) mindestens einen ersten Verstärker (140) und einen zweiten Verstärker (140) aufweist, wobei der erste Verstärker eingerichtet ist, das erste Abbild mittels einer ersten Gegenkopplung (142) zum ersten Ausgangssignal (191) zu transformieren, und wobei der zweite Verstärker (150) eingerichtet ist, das zweite Abbild mit einer zweiten Gegenkopplung (152) zum zweiten Ausgangssignal (192) zu transformieren.

**10.** Der Spannungsverstärker (100, 300) gemäß Anspruch 9, wobei die erste Gegenkopplung (142) gleich der zweiten Gegenkopplung (152) ist, wobei der Spannungsverstärker (100, 300) eingerichtet ist, das erste Ausgangssignal (191) mittels des ersten Verstärkers (140) um den ersten Verstärkungsfaktor zu verstärken, und wobei der Spannungsverstärker (100, 300) weiter eingerichtet ist, das zweite Ausgangssignal (192) mittels des zweiten Verstärkers (150) um den zweiten Verstärkungsfaktor zu verstärken, und der erste Verstärkungsfaktor gleich dem zweiten Verstärkungsfaktor ist.

**11.** Eine Analog-Digital-Wandler Schaltungsanordnung (500) umfassend mindestens einen Spannungsverstärker (100, 300) gemäß einem der vorangehenden Ansprüche und mindestens einen Analog-Digital-Wandler (510), wobei der Analog-Digital-Wandler (510) eingerichtet ist mindestens das erste Ausgangssignal (191) in ein erstes digitales Signal (531) zu wandeln und mindestens das zweite Ausgangssignal (192) in ein zweites digitales Signal (531) zu wandeln.

**12.** Die Analog-Digital-Wandler Schaltungsanordnung (500) gemäß Anspruch 11, wobei das erste digitalen Signal (531) einen ersten linear transformierten Bereich des Eingangsspannungssignals (10) repräsentiert, wenn das erste digitale Signal (531) einen ersten Wert aufweist, wobei der erste Wert größer ist als ein erster minimaler digitaler Wert und kleiner als ein erster maximaler digitaler Wert, und wobei das zweite digitale Signal (531) einen zweiten linear transformierten Bereich des Eingangsspannungssignals (10) repräsentiert, wenn das zweite digitale Signal (531) einen zweiten Wert aufweist, wobei der zweite Wert größer ist als ein zweiter minimaler digitaler Wert und kleiner als ein zweiter maximaler digitaler Wert.

**13.** Ein Verfahren zur Spannungsverstärkung für einen programmierbaren Spannungsbereich umfassend die Schritte:

- Transformieren eines Eingangsspannungssignals (10), so dass ein erster Bereich (12) des Eingangsspannungssignals (10) in einen ersten definierten Bezug zu einem ersten Arbeitspunkt einer Verstärkerschaltung (130) gesetzt wird, wobei das Eingangsspannungssignal (10) in ein Eingangsstromsignal transformiert wird und mittels des Eingangsstromsignals ein erstes Abbild des ersten Bereichs des Eingangsspannungssignal (10) zur Verfügung gestellt wird, sodass das erste Abbild den ersten Arbeitspunkt in Bezug auf das Eingangsspannungssignal (10) umfasst,

- Transformieren des Eingangsspannungssignals (10), so dass ein zweiter Bereich (14) des Eingangsspannungssignals (10) in einen zweiten definierten Bezug zu einem zweiten Arbeitspunkt der Verstärkerschaltung (130) gesetzt wird, wobei mittels des Eingangsstromsignals ein zweites Abbild des zweiten Bereichs des Eingangsspannungssignal (10) zur Verfügung gestellt wird, sodass das zweite Abbild den zweiten Arbeitspunkt in Bezug auf das Eingangsspannungssignal (10) umfasst,

- Linear Transformieren des ersten Bereiches (12) mittels des ersten Abbilds zu einem ersten Ausgangssignal (191), und

- Linear Transformieren des zweiten Bereiches (14) mittels des zweiten Abbilds zu einem zweiten Ausgangssignal (192).

14. Ein Verfahren zur Digitalisierung des Eingangsspannungssignals (10) umfassend die Schritte gemäß Anspruch 13, weiter umfassend die Schritte:

- Digitalisieren des ersten Ausgangssignals (191), und
- Digitalisieren des zweiten Ausgangssignals (192).

**Claims**

1. A voltage amplifier (100, 300) for a programmable voltage range, whereby the voltage amplifier (100, 300) has at least a first and a second operating point relative to an input voltage signal (10), and whereby the voltage amplifier (100, 300) is configured to linearly transform a first range (12) of the input voltage signal (10) into a first output signal (191) by means of the first operating point, and whereby the voltage amplifier (100, 300) is also configured to linearly transform a second range (14) of the input voltage signal (10) into a second output signal (192) by means of the second operating point, whereby the voltage amplifier (100, 300) has a control stage (110), at least one input reference resistor arrangement (120, 330) and an amplifier circuit (130), whereby the control stage (110) is configured to transform the input voltage signal (10) into an input current signal, the at least one input reference resistor arrangement (120, 330) is configured to use the input current signal in order to provide a first image of the first range (12) of the input voltage signal (10) and a second image of the second range (14) of the input voltage signal (10), so that the first image encompasses the first operating point relative to the input voltage signal (10), and the second image encompasses the second operating point relative to the input voltage signal (10), and whereby the amplifier circuit (130) is configured to transform the first image into the first output signal (191) and the second image into the second output signal (192).

2. The voltage amplifier (100, 300) according to claim 1, whereby the voltage amplifier (100, 300) has a variable operating point so that, aside from the first and second operating points, additional operating points can be set relative to the input voltage signal (10).

3. The voltage amplifier (100, 300) according to claim 1, whereby the voltage amplifier (100, 300) is configured to simultaneously provide the first and second operating points.

4. The voltage amplifier (100, 300) according to claim 3, whereby the first and second operating points are set in such a way that the first range (12) of the input voltage signal (10) and the second range (14) of the input voltage signal (10) have at least one shared value.

5. The voltage amplifier (100, 300) according to claim 4, whereby the first range (12) of the input voltage signal (10) and the second range (14) of the input voltage signal (10) are adjacent to each other.

6. The voltage amplifier (100, 300) according to one of the preceding claims, whereby the voltage amplifier (100, 300) is configured to amplify the first output signal (191) by a prescribed first amplification factor with respect to the first range (12) of the input voltage signal (10), and whereby the voltage amplifier (100, 300) is configured to amplify the second output signal (192) by a prescribed second amplification factor with respect to the second range of the input voltage signal (10),

7. The voltage amplifier (100, 300) according to claim 6, whereby the amplifier circuit (130) is configured to transform the first image into a first output current and the second image into a second output current, and whereby the amplifier circuit (130) is also configured so that, via a first output reference resistor (137), it emits the first output signal (191) as a voltage drop of the first output current and so that, via a second output reference resistor (137), it emits the second output signal as a voltage drop of the second output current.

8. The voltage amplifier (100, 300) according to claim 7, whereby the amplifier circuit (130) is configured to amplify the first output current by a defined first current amplification factor with respect to the input current signal and to amplify the second output current by a defined second current amplification factor with respect to the input current signal.

9. The voltage amplifier (100, 300) according to claim 1, whereby the amplifier circuit (130) has at least a first amplifier (140) and a second amplifier (140), whereby the first amplifier is configured to transform the first image into the first output signal (191) by means of a first negative feedback (142), and whereby the second amplifier (150) is configured to transform the second image into the second output signal (192) by means of a second negative feedback (152).

10. The voltage amplifier (100, 300) according to claim 9, whereby the first negative feedback (142) is equal to the second negative feedback (152), whereby the voltage amplifier (100, 300) is configured to amplify the first output signal (191) by the first amplification factor using the first amplifier (140), and whereby the voltage amplifier (100, 300) is also configured to amplify the second output signal (192) by the second amplification factor using the second amplifier (150), and the first amplification factor is the same as the second amplification factor.

11. An analog-to-digital converter circuit arrangement (500) comprising at least one voltage amplifier (100, 300) according to one of the preceding claims and at least one analog-to-digital converter (510), whereby the analog-to-digital converter (510) is configured to convert at least the first output signal (191) into a first digital signal (531) and to convert at least the second output signal (192) into a second digital signal (531).

12. The analog-to-digital converter circuit arrangement (500) according to claim 11, whereby the first digital signal (531) represents a first linearly transformed range of the input voltage signal (10) when the first digital signal (531) has a first value, whereby the first value is greater than a first minimum digital value and smaller than a first maximum digital value, and whereby the second digital signal (531) represents a second linearly transformed range of the input voltage signal (10) when the second digital signal (531) has a second value, whereby the second value is greater than a second minimum digital value and smaller than a second maximum digital value.

13. A method for voltage amplification for a programmable voltage range, encompassing the following steps:

- transforming an input voltage signal (10) so that a first range (12) of the input voltage signal (10) is placed in a first defined relation to a first operating point of an amplifier circuit (130), whereby the input voltage signal (10) is transformed into an input current signal and, by means of the input current signal, a first image of the first range of the input voltage signal (10) is provided, so that the first image encompasses the first operating point relative to the input voltage signal (10);
- transforming the input voltage signal (10) so that a second range (14) of the input voltage signal (10) is placed in a second defined relation to a second operating point of the amplifier circuit (130), whereby, by means of the input current signal, a second image of the second range of the input voltage signal (10) is provided, so that the second image encompasses the second operating point relative to the input voltage signal (10);
- linearly transforming the first range (12) by means of the first image into a first output signal (191); and
- linearly transforming the second range (14) by means of the second image into a second output signal (192).

14. A method for digitizing the input voltage signal (10), encompassing the steps according to claim 13, and also encompassing the following steps:

- digitizing the first output signal (191); and
- digitizing the second output signal (192).

**Revendications**

1. Amplificateur de tension (100, 300) pour une plage de tension programmable, l'amplificateur de tension (100, 300) comportant au moins un premier et un deuxième point de fonctionnement en relation avec un signal de tension d'entrée (10), et l'amplificateur de tension (100, 300) étant agencé pour, au moyen du premier point de fonctionnement, transformer de façon linéaire une première plage (12) du signal de tension d'entrée (10) en un premier signal de sortie (191), et l'amplificateur de tension (100, 300) étant également agencé pour, au moyen du deuxième point de fonctionnement, transformer de façon linéaire une deuxième plage (14) du signal de tension d'entrée (10) en un deuxième signal de sortie (192), l'amplificateur de tension (100, 300) comportant un étage de régulation (110), au moins un ensemble de résistance de référence d'entrée (120, 330) et un circuit d'amplification (130), l'étage de régulation (110) étant agencé pour transformer le signal de tension d'entrée (10) en un signal de courant d'entrée, au moins un de l'ensemble de résistance de référence d'entrée (120, 330) n'étant agencé pour, au moyen du signal de courant d'entrée, mettre à disposition une première image de la première plage (12) du signal de tension d'entrée (10) et une deuxième image de la deuxième plage (14) du signal de tension d'entrée (10) de telle sorte que la première image comprend le premier point de fonctionnement en relation avec le signal de tension d'entrée (10), et la deuxième image comprend le deuxième point de fonctionnement en relation avec le signal de tension d'entrée (10), et le circuit d'amplification (130) étant agencé pour transformer la première image en premier signal de sortie (191,) et la deuxième image en deuxième signal de sortie (192).

2. Amplificateur de tension (100, 300) selon la revendication 1, dans lequel l'amplificateur de tension (100, 300) comporte un point de fonctionnement réglable de telle sorte que, outre le premier et le deuxième point de fonctionnement, d'autres points de fonctionnement en relation avec le signal de tension d'entrée (10) peuvent être réglés.

3. Amplificateur de tension (100, 300) selon la revendication 1, dans lequel l'amplificateur de tension (100, 300) est agencé pour mettre à disposition en même temps le premier point de fonctionnement et le deuxième point de fonctionnement.

4. Amplificateur de tension (100, 300) selon la revendication 3, dans lequel le premier point de fonctionnement et le deuxième point de fonctionnement sont réglés de telle sorte que la première plage (12) du signal de tension d'entrée (10) et la deuxième plage (14) du signal de tension d'entrée (10) présentent au moins une valeur commune.

5. Amplificateur de tension (100, 300) selon la revendication 4, dans lequel la première plage (12) du signal de tension d'entrée (10) et la deuxième plage (14) du signal de tension d'entrée (10) sont adjacentes.

6. Amplificateur de tension (100, 300) selon l'une des revendications précédentes, dans lequel l'amplificateur de tension (100, 300) est agencé pour amplifier le premier signal de sortie (191) selon un premier facteur d'amplification prédéfini par rapport à la première plage (12) du signal de tension d'entrée (10), et l'amplificateur de tension (100, 300) est agencé pour amplifier le deuxième signal de sortie (192) selon un deuxième facteur d'amplification prédéfini par rapport à la deuxième plage du signal de tension d'entrée (10).

7. Amplificateur de tension (100, 300) selon la revendication 6, dans lequel le circuit d'amplification (130) est agencé pour transformer la première image en un premier courant de sortie et la deuxième image en un deuxième courant de sortie, et le circuit d'amplification (130) est également agencé pour délivrer le premier signal de sortie (191) en tant que chute de tension du premier courant de sortie par le biais d'une première résistance de référence de sortie (137), et pour délivrer le deuxième signal de sortie en tant que chute de tension du deuxième courant de sortie par le biais d'une deuxième résistance de référence de sortie (137).

8. Amplificateur de tension (100, 300) selon la revendication 7, dans lequel le circuit d'amplification (130) est agencé pour amplifier le premier courant de sortie selon un premier facteur d'amplification de courant défini par rapport au signal de courant d'entrée, et pour amplifier le deuxième courant de sortie selon un deuxième facteur d'amplification de courant défini par rapport au signal de courant d'entrée.

9. Amplificateur de tension (100, 300) selon la revendication 1, dans lequel le circuit d'amplification (130) comporte au moins un premier amplificateur (140) et un deuxième amplificateur (140), le premier amplificateur étant agencé pour, au moyen d'une première contre-réaction (142), transformer la première image en premier signal de sortie (191), et le deuxième amplificateur (150) étant agencé pour, avec une deuxième contre-réaction (152), transformer la deuxième image en deuxième signal de sortie (192).

10. Amplificateur de tension (100, 300) selon la revendication 9, dans lequel la première contre-réaction (142) est identique à la deuxième contre-réaction (152), l'amplificateur de tension (100, 300) étant agencé pour, au moyen du premier amplificateur (140), amplifier le premier signal de sortie (191) selon le premier facteur d'amplification, et l'amplificateur de tension (100, 300) étant également agencé pour, au moyen du deuxième amplificateur (150), amplifier le deuxième signal de sortie (192) selon le deuxième facteur d'amplification, et le premier facteur d'amplification étant identique au deuxième facteur d'amplification.

11. Ensemble de circuit (500) convertisseur analogique/numérique, comprenant au moins un amplificateur de tension (100, 300) selon l'une des revendications précédentes, et au moins un convertisseur analogique/numérique (510), dans lequel le convertisseur analogique/numérique (510) est agencé pour convertir au moins le premier signal de sortie (191) en un premier signal numérique (531) et pour convertir au moins le deuxième signal de sortie (192) en un deuxième signal numérique (531).

12. Ensemble de circuit (500) convertisseur analogique/numérique selon la revendication 11, dans lequel le premier signal numérique (531) représente une première plage, transformée de façon linéaire, du signal de tension d'entrée (10) quand le premier signal numérique (531) présente une première valeur, la première valeur étant supérieure à une première valeur numérique minimale et inférieure à une première valeur numérique maximale, et le deuxième signal numérique (531) représente une deuxième plage, transformée de façon linéaire, du signal de tension d'entrée (10) quand le deuxième signal numérique (531) présente une deuxième valeur, la deuxième valeur étant supérieure à une deuxième valeur numérique minimale et inférieure à une deuxième valeur numérique maximale.

13. Procédé d'amplification de tension pour une plage de tension programmable, comprenant les étapes suivantes :

   - transformation d'un signal de tension d'entrée (10) de telle sorte qu'une première plage (12) du signal de tension d'entrée (10) est placée dans une première relation définie avec un premier point de fonctionnement d'un circuit d'amplification (130), le signal de tension d'entrée (10) étant transformé en un signal de courant d'entrée et, au moyen du signal de courant d'entrée, une première image de la première plage du signal de tension d'entrée (10) étant mise à disposition, de telle sorte que la première image comprend le premier point de fonctionnement en relation avec le signal de tension d'entrée (10),

- transformation du signal de tension d'entrée (10) de telle sorte qu'une deuxième plage (14) du signal de tension d'entrée (10) est placée dans une deuxième relation définie en relation avec un deuxième point de fonctionnement du circuit d'amplification (130), une deuxième image de la deuxième plage du signal de tension d'entrée (10) étant mise à disposition au moyen du signal de courant d'entrée, de telle sorte que la deuxième image comprend le deuxième point de fonctionnement en relation avec le signal de tension d'entrée (10),

- transformation linéaire de la première plage (12) au moyen de la première image en un premier signal de sortie (191), et

- transformation linéaire de la deuxième plage (14) au moyen de la deuxième image en un deuxième signal de sortie (192).

14. Procédé de numérisation du signal de tension d'entrée (10), comprenant les étapes selon la revendication 13, comprenant également les étapes suivantes :

- numérisation du premier signal de sortie (191), et
- numérisation du deuxième signal de sortie (192).

**Fig. 1**

EP 3 320 619 B1

Fig. 2

**Fig. 3**

Fig. 4

Fig. 5

Fig. 6

**Fig. 7**

710 ⎯[                    ]

720 ⎯[                    ]

730 ⎯[                    ]

740 ⎯[                    ]

**Fig. 8**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20140232577 A1
- WO 2004051858 A2